# EUROPÄISCHE PATENTSCHRIFT

(11) **EP 0 428 016 B1**
(45) Veröffentlichungstag und Bekanntmachung des Hinweises auf die Patenterteilung: **12.04.1995**
(21) Anmeldenummer: 90120934.6
(22) Anmeldetag: 31.10.1990
(51) Int. Cl.: H04B 10/14

(54) **Modulationsstromregelung für Laserdioden**
Laser diode modulation current control
Commande de courant de modulation pour diodes laser

(30) Priorität: 13.11.1989 DE 3937747
(43) Veröffentlichungstag der Anmeldung: 22.05.1991
(73) Patentinhaber: SIEMENS AKTIENGESELLSCHAFT, 80333 München (DE)
(72) Erfinder: Proebster, Walter, D-8000 München 90 (DE)

(56) Entgegenhaltungen:
- EP-A- 0 075 295
- ELECTRONICS LETTERS, Bd. 14, Nr. 24, 23. November 1978, STEVENAGE, GB Seiten 775 - 776; SMITH: 'Laser level control circuit for high-bit-rate systems using a slope-detector'
- PROCEEDINGS OF THE 4TH EUROPEAN CONFERENCE OF OPTICAL COMMUNICATION 1978, GENOA Seiten 438 - 448; BROSIO, CARNI, MONCALVO, SEANO: 'Level control circuit injection for laser transmitters'

## Beschreibung

Die Erfindung betrifft ein Verfahren zur Regelung des Modulationsstroms von Laserdioden und Anordnungen zur Durchführung des Verfahrens.

Beim Einsatz von Laserdioden als optische Sender in Lichtwellenleiter-Übertragungssystemen muß der Arbeitspunkt dieser Bauelemente gegenüber Alterung und Temperaturveränderungen durch ein geeignetes Regelungsverfahren konstant gehalten werden. Da die Kennlinie der im allgemeinen verwendeten Laserdioden einen deutlichen Schwellenwert aufweist, besteht die Arbeitspunktregelung der Laserdioden in der Regelung eines Vorstroms und einer Regelung des dem Vorstrom überlagernden Modulationsstroms im Kennlinienbereich der eigentlichen Laseremission oberhalb der Schwelle. Sowohl Laserdioden-Schwellenstrom als auch Kennliniensteigung oberhalb der Schwelle sind alterungs- und temperaturbedingten Veränderung unterworfen und erforden daher eine entsprechende Nachführung von Vorstrom und Modulationsstrom. Zur Arbeitspunktregelung wird im allgemeinen mittels einer optisch mit der Laserdiode gekoppelten Monitorfotodiode ein Teil des erzeugten Lichtes in ein elektrisches Signal umgewandelt und dieses zur Erzeugung eines Regelsignals verwendet. Bei einer wenig aufwendigen Regelung wird dabei der Vorstrom über die Auswertung der mittleren Lichtausgangsleistung nachgeführt und unter Verzicht auf eine Modulationsstromregelung der Modulationsstrom konstant gehalten.

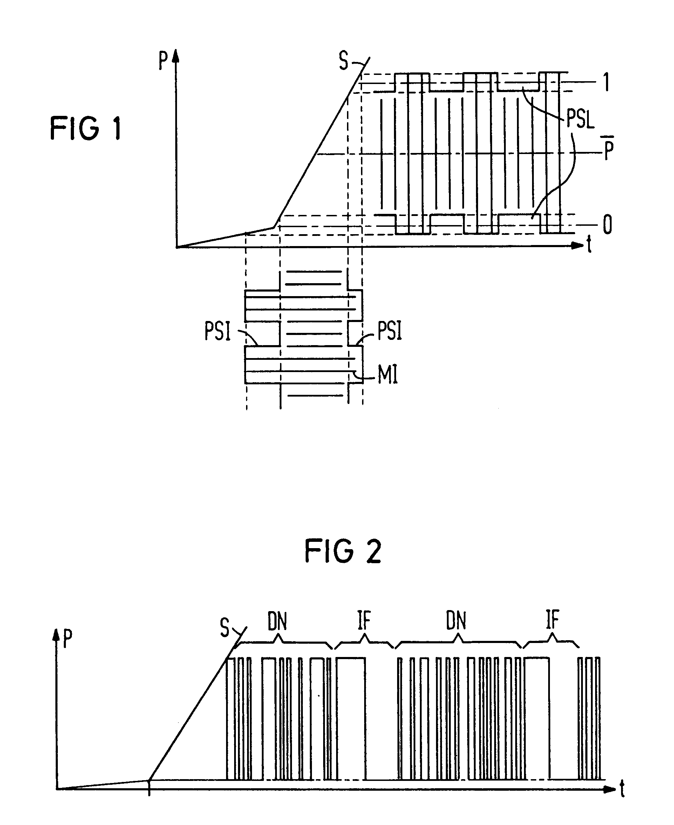

Bei einem aus Electronics Letters, VOL.14pp 775-776 (1978) von Smith und Hodgkinson beschriebenen Verfahren zur Arbeitspunktregelung von Laserdioden wird entsprechend Figur 1 dem Modulationsstrom MI ein vergleichsweise niederfrequenter Pilotstrom PSI überlagert, der einen entsprechenden Pilotsignalanteil PSL im erzeugten Licht bewirkt. Bei diesem Verfahren ergibt sich eine genaue Arbeitspunktstabilisierung des Vorstroms im Bereich des Schwellenstroms und aufgrund einer kombinierten Auswertung der mittleren Lichtausgangsleistung sowie der Kennliniensteilheitsauswertung im Arbeitspunkt eine Einstellung der Lichtsignalamplitude durch die Regelung des Modulationsstroms.

Die Weiterentwicklung der digitalen Signalübertragung ergibt digitale Nutzsignale mit Bitraten im Gigabit/s-Bereich, bei denen sich, sofern der Vorstrom unterhalb des Schwellenstromsbereichs eingestellt ist, durch Einschaltverzögerungen und Relaxationsschwingen der Laserdiode Störungen ergeben können. Für diesen Kennlinien-Arbeitsbereich kommt das bekannte und bewährte Verfahren der relativen Kennliniensteilheitsauswertung nicht in Betracht, da der Vorstrom oberhalb des Schwellenstrombereichs eingestellt werden muß.

Eine Möglichkeit zur Regelung von Lasersendern für Nutzsignale im Gigabit/s-Bereich ist die Regelung nur des Vorstroms bei konstantem Modulationsstrom oder in Verbindung mit einer vereinfachten Modulationsstromregelung. Dabei können sich jedoch Schwierigkeiten dadurch ergeben, daß durch eine Alterung der Laserdiode die Kennliniensteilheit verändert wird und auch nichtlineare Kennlinienveränderungen auftreten können. Eine direkte Auswertung der Lichtsignalamplitude des digitalen Nutzsignals ist zwar denkbar, erfordert jedoch wegen der hohen Frequenzbandbreite des digitalen Nutzsignals ein vergleichsweise hohen Aufwand insbesondere für die Modulationsstromregelung, während die Vorstromregelung mit bekannten Verfahren erfolgen kann.

Die Aufgabe bei der vorliegenden Erfindung besteht also darin, ein Verfahren sowie Anordnungen zur Durchführung des Verfahrens für die Modulationsstromregelung von Laserdioden im Gigabit-Bereich anzugeben.

Die Aufgabe wird erfindungsgemäß durch ein Regelungsverfahren der eingangs erwähnten Art gelöst, das durch die im Kennzeichen des Patentanspruchs 1 enthaltenen Merkmale weitergebildet ist. Von besonderem Vorteil beim erfindungsgemäßen Verfahren ist die Möglichkeit, mit Signalen arbeiten zu können, deren Frequenz um 1-2 Zehnerpotenzen unterhalb der Impulsfolgefrequenz der digitalen Nutzsignale liegt. Eine bevorzugte Ausbildung des erfindungsgemäßen Verfahrens, die von im digitalen Signal auftretenden niederfrequenten Komponenten Gebrauch macht und dadurch besonders wenig aufwendig ist, ist im Patentanspruch 2 beschrieben. Zweckmäßige Verfahren zur Auswertung des von der Monitorfotodiode erzeugten elektrischen Signals sind in den Patentansprüchen 3 und 4 beschrieben, während entsprechende Anordnungen, die mit handelsüblichen Bauelementen realisiert werden können, in den Patentansprüchen 5 und 6 beschrieben sind.

Die Erfindung soll im folgenden anhand eines in der Zeichnung dargestellten Ausführungsbeispiel näher erläutert werden.

Dabei zeigt
- Figur 1: ein bekanntes Prinzip der Pilotsignalregelung von mittels Laserdioden aufgebauten Lichtsendern,
- Figur 2: des bei der erfindungsgemäßen Laserregelung erzeugte Lichtsignal,
- Figur 3: eine erste Anordnung zur Auswertung des von der Monitor-Fotodiode erzeugten elektrischen Signals unter Anwendung feines Synchrondetektors und
- Figur 4: eine weitere Anordnung zur Auswertung des von der Monitor-Fotodiode erzeugten elektrischen Signals unter Anwendung einer Abtast- und Halteschaltung.

Die Figur 1 ist bei der Besprechung des Standes der Technik bereits miterläutert worden, sodaß an dieser Stelle nicht weiter darauf eingegangen werden soll.

Die Figur 2 zeigt eine vereinfachte Darstellung einer Laserdiodenkennlinie S und des von der Laserdiode erzeugten impulsförmigen Lichtsignals oberhalb der Grundlicht- bzw. Gleichlichtlinie GLL. Das Lichtsignal stellt das digitale Übertragungssignal dar, das aus dem digitalen Nutzsignal DN und einer periodisch auftauchenden Impulsfolge IF besteht und mittels NRZ-Impulsen übertragen wird. Die Darstellung ist dabei insofern vereinfacht, als die für die Modulationsstromregelung vorgesehene Impulsfolge IF in Wirklichkeit nicht derart kurzperiodisch auftritt und gegenüber dem digitalen Nutzsignal DN auch nicht einen derart großen Anteil am Übertragungssignal hat. Aus der Figur 2 ist ersichtlich, daß die für die Regelung vorgesehene Impuls folge im Gegensatz zu den pseudozufällig auftretenden Impulsen des digitalen Nutzsignals immer den gleichen Aufbau aufweist, beim Ausführungsbeispiel ist es jeweils ein Block aus mehreren logischen Einsimpulsen gefolgt von einer Anzahl logischer Nullen. Aus der Figur 2 ist weiterhin erkennbar, daß die Amplituden der logischen Einsimpulse gleich denen der Impulse des digitalen Nutzsignals DN sind, die Amplitude der Impulsfolge IF ist also direkt ein Maß für den Modulationshub an der Laserdiode, die Impulsfolge tritt dabei mit einer gegenüber dem digitalem Nutzsignal DN erkennbar deutlich geringeren Frequenz auf und ist damit leichter als das digitale Nutzsignal DN auszuwerten.

Die für die Modulationsstromregelung vorgesehene Impulsfolge IF kann periodisch in freien Kanälen des digitalen Übertragungssignals in dieses eingeblendet werden, eine besonders vorteilhafte und einfache Möglichkeit ist aber die Verwendung einer bereits im digitalen Übertragungssignal periodisch enthaltenen unverwürfelten Impulsfolge mit stark unterschiedlichen Anteilen logischer Null- und Einsimpulse, wie dies durch die neue, mit SONET bezeichnete internationale Digitalsignal-Hierarchie entsprechend den CCITT-Empfehlungen G.707, G.708 und G.709 möglich ist. Bei dieser Digitalsignal-Hierarchie ist bei den Hierarchiestufen STM-1, STM-4 und STM-16 Jeweils ein 125 »s dauernder Rahmen vorgesehen, der an seinem Beginn für die Dauer von ca. 310 ns eine Folge von unverwürfelten Rahmenkennworten aufweist. Die Rahmenkennwortfolge besteht dabei aus einer Anzahl von ersten Rahmenkennworten A1 gefolgt von einer Anzahl zweiten Rahmenkennworten A2. Die Rahmenkennworte weisen dabei folgenden Aufbau auf:
A1: 1 1 1 1 0 1 1 0
A2: 0 0 1 0 1 0 0 0

Es ist erkennbar, daß das erste Rahmenkennwort A1 einen überwiegenden Anteil logischer Einsimpulse aufweist, während das zweite Rahmenkennwort A2 überwiegend aus logischen Nullimpulsen besteht, so daß die Kombination beider Rahmenkennworte eine Impulsfolge ergibt, die in einem Teil überwiegend logische Einsimpulse und im anderen Teil überwiegend logische Nullimpulse enthält.

Bei der mit STM-1 bezeichneten ersten SONET-Hierarchiestufe wird ein digitales Übertragungssignal mit einer Bitrate von 155 Mbit/s übertragen, die Rahmenkennwortfolge besteht aus drei ersten Rahmenkennworten A1 gefolgt von drei zweiten Rahmenkennworten A2. Bei einer Bitperiode von ca. 6,5 ns ergeben sich für die 48 Bitpositionen der Rahmenkennwortfolge insgesamt ca. 310 ns als Periodendauer.

Bei der mit STM-4 bezeichneten zweiten SONET-Hierarchiestufe weist das digitale Übertragungssignal eine Bitrate von 622 Mbit/s auf, die unverwürfelte Rahmenkennwortfolge besteht aus 12 ersten Rahmenkennworten A1 und 12 zweiten Rahmenkennworten A2, so daß sich ebenfalls ein Pulssignal mit einer Dauer von ca. 310 ns ergibt.

Die mit STM-16 bezeichnete dritte SONET-Hierarchiestufe bezieht sich auf ein digitales Übertragungssignal von 2,5 Gbit/s, die Rahmenkennwortfolge besteht aus 48 ersten Rahmenkennworten A1 und der gleichen Anzahl zweiter Rahmenkennworte A2, so daß sich auch in diesem Falle ein Pulssignal mit einer dauer von etwa 310 ns ergibt, daß nach jeweils 125 »s auftaucht. In dem von der Laserdiode ausgesendeten Licht ist damit ein tieffrequenter Signalanteil erhalten, dessen Auswertung eine einfache Regelung der Modulationsstromamplitude der Laserdiode gestattet.

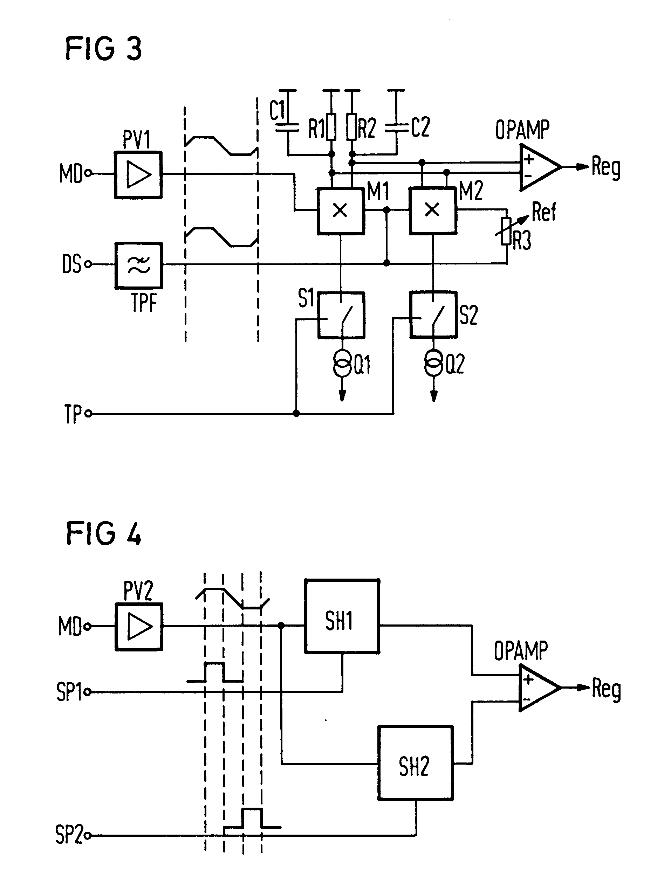

Die Auswertung der Lichtsignalamplitude kann entsprechend Figur 3 mittels Synchrondetektion oder entsprechend Figur 4 mittels Abtast- und Halteschaltungen erfolgen. Die in der Figur 3 dargestellte Auswerteschaltung für die Lichtsignalamplitude enthält eine ersten Fotostromverstärker PV1, dessen Eingang mit der Monitorfotodiode MD verbunden ist und an dessem Ausgang ein dem Lichtsignal entsprechendes elektrisches Signal ansteht, das einem ersten Eingang einer ersten Gegentakt-Mischerstufe M1 zugeführt wird. Die Auswerteschaltung ist außerdem über einen Tiefpaß TP an einen Anschluß DS für das die Laserdiode modulierende digitale Signal angeschlossen, der Ausgang des Tiefpasses TP ist mit einem zweiten Eingang der ersten Gegentakt-Mischerstufe M1 verbunden, während der erste und der zweite Stromausgangsanschluß dieser Mischerstufe M1 über einen ersten bzw. zweiten Widerstand R1, R2 und diesen parallel geschaltete erste bzw. zweite Kondensatoren C1, C2 mit Bezugspotential verbunden sind. Der gemeinsame Stromanschluß der Mischerstufe M1, also beispielsweise die zusammengeführten Emitteranschlüsse einer emittergekoppelten Transistor-Mischerschaltung sind mit dem Ausgangsanschluß eines ersten gesteuerten Schalters S1 verbunden, dessen Eingangsanschluß mit einer ersten Stromquelle Q1 und dessen Steuereingang mit einem Anschluß TP für einen Torpuls verbunden ist. Dieser Torpuls entspricht hinsichtlich seines zeitlichen Auftretens und seiner Dauer der Impulsfolge IF im Lichtausgangssignal der Laserdiode, also der Dauer DRKW der Rahmenkennwortfolge des für die Übertragung vorgesehenen SONET-Systems STM-1, 4 oder 16. Mit dem Ausgangsanschluß für den Tiefpaß TPF ist außerdem direkt der zweite Eingang einer zweiten Gegentakt-Mischerstufe M2 und über einen dritten, einstellbaren Widerstand R3 der erste Eingang dieser zweiten Mischerstufe M2 verbunden. Durch diesen dritten Widerstand R3 ist die Einstellung einer Referenzspannung und damit die Einstellung der gewünschten Aussteuerung der Laserdiode möglich. Die beiden Ausgangsanschlüsse der zweiten Mischerstufe M2 sind über Kreuz mit den Ausgangsanschlüssen der ersten Mischerstufe M1 und mit einem Operationsverstärker OPAMP verbunden, an dessen Ausgang ein Steueranschluß des Modulationsstromreglers Reg angeschlossen ist. Entsprechend der ersten Mischerstufe M1 sind auch die zusammengeführten Anschlüsse der zweiten Mischerstufe M2 mit dem Ausgang eines zweiten gesteuerten Schalters S2 verbunden, dessen Eingangsanschluß mit einer zweiten Stromquelle Q2 und dessen Steuereingang mit dem Anschluß TP für den Torpuls verbunden sind.

Die Synchrondetektion erfolgt so, daß durch den Torpuls mit einer Dauer von etwa 310 ns der erste und der zweite gesteuerte Schalter S1, S2 geschlossen und damit die erste und die zweite Mischerstufe M1, M2 gegenphasig aktiviert werden. Die erste Mischerstufe M1 führt die Synchrondetektion des von der Laserdiode erzeugten Lichtwertes mit dem an die Laserdiode angelegten Wert aus, während die zweite Mischerstufe M2 eine Referenzsignalbildung über das an der Laserdiode anliegende Modulationssignal selbst durchführt. Die Mittelwertsbildung der mittels des Torpulses getakteten Synchrondetektion erfolgt dabei im Ausgangskreis des Synchrondetektors.

In der Figur 4 ist eine Auswerteschaltung der Lichtsignalamplitude mittels Abtast- und Halteschaltungen dargestellt. Dabei ist die Monitor-Fotodiode MD über einen zweiten Fotoverstärker PV2 mit den Eingängen einer ersten und einer zweiten handelsüblichen Abtast- und Halteschaltung SH1, SH2 verbunden. Die Fotoverstärker sowie die Abtast- und Halteschaltungen können bei der erforderlichen Frequenzbandbreite von etwa 20 MHz vorteilhaft mit diskreten Mikrowellenhalbleiterkomponenten aufgebaut werden. Die Steuereingänge dieser beiden Abtast- und Halteschaltungen sind außerdem mit Anschlüssen SP1, SP2 für Synchronimpulse verbunden. Die Synchronimpulse entsprechen dabei in ihrer zeitlichen Lage maximal den Teilen der Impulsfolge IF, also entweder dem Teil, in dem die logischen Null oder dem Teil, in dem die logischen Einsimpulse überwiegen. Zur Sicherheit gegen Überlappung ist es dabei zweckmäßig, die Synchronimpulse soweit zu verkürzen, daß eine Dauer eines Synchron impulses deutlich kürzer ist als die halbe Dauer der Impulsfolge IF bzw. der halben Dauer des Torpulses TP nach der Figur 3.

Beim Ausführungsbeispiel wurde der ersten Abtast- und Halteschaltung SH1 ein erster Synchronimpuls SP1 zugeführt, der während der logischen Einsimpulse in der Impulsfolge IF wirksam ist, während der zweiten Abtast- und Halteschaltungen SH2 ein zweiter Synchronimpuls SP2 zugeführt wird, der während der Dauer des überwiegend aus logischen Nullimpulsen bestehenden Teils der Impuls folge IF wirksam ist. Ähnlich der Fig. 3 ist der Ausgang der ersten Abtast- und Halteschaltung SH1 mit dem positiven und der Ausgang der zweiten Abtast- und Halteschaltung SH2 mit dem negativen Eingang des Operationsverstärkers OPAMP verbunden, an dessem Ausgang ein Steueranschluß des Modulationsstromreglers Reg angeschlossen ist.

Die Lichtsignalamplitudenauswertung im Rahmenkennwort mittels Abtast- und Halteschaltungen erfolgt also durch Synchronisationsimpulse gesteuert zeitgleich mit der übertragenen Rahmenkennwortfolge. Die Mittelwertbildung und der Amplitudenreferenzvergleich erfolgen dabei in dem nachgeschalteten Operartionsverstärker, der nur für den NF-Bereich wirksam sein muß.

Bei den Figuren 3 und 4 kann auf in sehr vorteilhafter Weise Schaltungen verzichtet werden, die in ihrem Arbeitsbereich dem großen Frequenzbereich des digitalen Nutzsignals entsprechen, selbst bei einem Übertragungssignal entsprechen der SONET-Hierarchiestufe STM-16, also einer Übertragungsgeschwindigkeit von 2,5 Gbit/s ist für die verwendeten Fotostromverstärker, Abtast- und Halteschaltungen, Differenzverstärker und gesteuerten Schalter eine Arbeitsbandbreite von 20 MHz ausreichend.

## Patentansprüche

1. Verfahren zur Regelung des Modulationsstroms von als optischer Sender in digitalen Nachrichten-Übertragungssystemen hoher Bitrate eingesetzten Laserdioden, bei dem mittels einer, optisch mit der Laserdiode gekoppelten Monitor-Fotodiode ein Teil des erzeugten Lichtes ausgekoppelt, in ein elektrisches Signal umgewandelt und zur Erzeugung eines Regelsignals verwendet wird,
**dadurch gekennzeichnet**,
daß das digitale Übertragungssignal periodisch wenigstens eine Impulsfolge (IF) enthält, die einen oder mehrere Teile enthält, in denen die logischen Null- oder die logischen Einsimpulse überwiegen, so daß ein von der Monitor-Fotodiode erzeugtes elektrisches Signal ein Pulssignal mit konstanter Amplitude und fester Zykluswiederkehr enthält, das einen vergleichsweise tieffrequenten Signalanteil ergibt, und
daß aus dessen Amplitudenwert durch Vergleich mit einem Referenzwert ein Stellsignal für die Modulationsstromregelung erzeugt wird.

2. Verfahren nach Patentanspruch 1,
**dadurch gekennzeichnet,**
daß die Impulsfolge (IF) einander abwechselnde Teile mit erhöhten Anteilen an logischen Eins- oder Nullimpulsen enthält.

3. Verfahren nach Patentanspruch 1,
**dadurch gekennzeichnet**,
daß das im digitalen Übertragungssignal periodisch enthaltene Pulssignal die unverwürfelte Rahmenkennwortfolge des digitalen Übertragungssignals ist.

4. Verfahren nach Patentanspruch 1,
**dadurch gekennzeichnet**,
daß die Erzeugung des Stellsignals für die Modulationsstromregelung durch Synchrondetektion des von der Monitor-Fotodiode erzeugten elektrischen Signals und Vergleich mit einem Referenzwert erfolgt.

5. Verfahren nach Patentanspruch 1,
**dadurch gekennzeichnet**,
daß die Erzeugung des Stellsignals für die Modulationsstromregelung aus dem von der Monitor- Fotodiode erzeugten elektrischen Signal mittels synchronisierter periodischer Abtastung des Signals und Integration der Abtastwerte nach Art des sogenannten "Sample and Hold"-Verfahrens erfolgt.

6. Anordnung zur Regelung des Modulationsstroms von als optischer Sender in digitalen Nachrichten-Übertragungssystemen hoher Bitrate eingesetzten Laserdioden nach Patentanspruch 4,
**dadurch gekennzeichnet,**
daß ein Fotoverstärker (PV1) vorgesehen ist, dessen Eingangsanschluß mit der Monitor-Fotodiode des optischen Senders und dessen Ausgangsanschluß mit dem einen Eingangsanschluß einer ersten Mischerstufe (M1) verbunden ist,
daß ein Tiefpaß (TPF) vorgesehen ist, dessen Eingangsanschluß mit einem das Übertragungssignal führenden Anschluß (DS) des optischen Senders und dessen Ausgangsanschluß mit den zweiten Anschlüssen der ersten und einer zweiten Mischerstufe (M1, M2) verbunden ist,
daß der erste Ausgangsanschluß der ersten Mischerstufe (M1) mit dem zweiten Ausgangsanschluß der zweiten Mischerstufe (M2), mit einem Anschluß (Reg) der nachgeschalteten Regeleinrichtung sowie über einen ersten Widerstand R1 und einen ersten Kondensator (C1) mit Bezugspotential verbunden ist,
daß der zweite Ausgangsanschluß der ersten Mischerstufe (M1) mit dem ersten Ausgangsanschluß der zweiten Mischerstufe (M2), sowie mit einem weiteren Anschluß (Reg 1, 2) für die nachgeschaltete Regeleinrichtung sowie über einen zweiten Widerstand (R2) und einen zweiten Kondensator (C2) mit Bezugspotential verbunden ist,
daß der erste Eingangsanschluß der zweiten Mischerstufe (M2) über einen dritten, einstellbaren Widerstand (R3) mit dem Ausgang des Tiefpasses (TPF) verbunden ist,
daß mit einem Anschluß (TP) für einen Torpuls die Steuereingänge eines ersten und eines zweiten gesteuerten Schalters (S1, S2) verbunden sind,
daß der Signaleingang des ersten gesteuerten Schalters (S1) mit einer ersten Stromquelle (Q1) und der Signaleingang des zweiten gesteuerten Schalters (S2) mit einer zweiten Stromquelle (Q2) verbunden sind und
daß der Signalausgang des ersten gesteuerten Schalters (S1) mit dem gemeinsamen Anschluß des ersten Differenzverstärkers (V1) und der Signalausgang des zweiten gesteuerten Schalters (S2) mit dem gemeinsamen Anschluß des zweiten Differenzverstärkers (V2) verbunden sind.

7. Anordnung zur Regelung des Modulationsstroms von als optischer Sender in digitalen Nachrichten-Übertragungssystemen hoher Bitrate eingesetzten Laserdioden nach Patentanspruch 5,
**dadurch gekennzeichnet,**
daß der Eingang eines Fotostromverstärkers (TV2) mit einem Anschluß der Monitor-Fotodiode (MD) des optischen Senders verbunden ist,
daß der Ausgang des Fotostromverstärkers (TV2) mit den Signaleingängen einer ersten und einer zweiten Abtast- und Halteschaltung (SH1, SH2) verbunden sind,
daß der Steuereingang der ersten Abtast- und Halteschaltung (SH1) mit einem ersten Anschluß (SP1) für einen ersten Synchronimpuls und der Steuereingang der zweiten Abtast- und Halteschaltung (SH2) mit einem zweiten Anschluß (SP2) für einen Synchronimpuls verbunden sind und
daß der Ausgang der ersten Abtast- und Halteschaltung (SH1) mit dem positiven und der Ausgang der zweiten Abtast- und Halteschaltung (SH2) mit dem negativen Eingang eines Operationsverstärkers (OPAMP) verbunden sind, an dessen Ausgang ein Anschluß der Regeleinrichtung für den Modulationsstrom der Laserdiode angeschlossen ist.

## Claims

1. Method for regulating the modulation current of laser diodes which are used as optical transmitters in high bit rate digital communications transmission systems, in which by means of a monitor photodiode optically coupled to the laser diode a portion of the generated light is coupled out, converted into an electrical signal and used to generate a regulating signal, characterized in that the digital transmission signal periodically contains at least one pulse train (IF) which contains one or more parts in which the logic zero or the logic one pulses predominate, with the result that an electrical signal generated by the monitor photodiode contains a pulse signal of constant amplitude and fixed cycle return which yields a comparatively low-frequency signal component, and in that from the amplitude value thereof a setting signal for regulating the modulation current is generated by comparison with a reference value.

2. Method according to Patent Claim 1, characterized in that the pulse train (IF) contains alternating parts having larger components of logic one or logic zero pulses.

3. Method according to Patent Claim 1, characterized in that the pulse signal periodically contained in the digital transmission signal is the unscrambled frame identifier sequence of the digital transmission signal.

4. Method according to Patent Claim 1, characterized in that the setting signal for regulating the modulation current is generated by synchronous detection of the electrical signal generated by the monitor photodiode and comparison with a reference value.

5. Method according to Patent Claim 1, characterized in that the setting signal for regulating the modulation current is generated from the electrical signal generated by the monitor photodiode by means of synchronized periodic sampling of the signal and integration of the sampled values in the manner of the so-called sample-and-hold method.

6. Arrangement for regulating the modulation current of laser diodes used as optical transmitters in high bit rate digital communications transmission systems according to Patent Claim 4, characterized in that a photo-amplifier (PV1) is provided whose input terminal is connected to the monitor photodiode of the optical transmitter and whose output terminal is connected to one input terminal of a first mixer stage (M1), in that a low-pass filter (TPF) is provided whose input terminal is connected to a terminal (DS), carrying the transmission signal, of the optical transmitter, and whose output terminal is connected to the second terminals of the first and a second mixer stage (M1, M2), in that the first output terminal of the first mixer stage (M1) is connected to the second output terminal of the second mixer stage (M2), to a terminal (Reg) of the downstream regulating system, and to reference potential via a first resistor (R1) and a first capacitor (C1), in that the second output terminal of the first mixer stage (M1) is connected to the first output terminal of the second mixer stage (M2), as well as to a further terminal (Reg 1, 2) for the downstream regulating system and to reference potential via a second resistor (R2) and a second capacitor (C2), in that the first input terminal of the second mixer stage (M2) is connected via a third, adjustable resistor (R3) to the output of the low-pass filter (TPF), in that the control inputs of a first and of a second controlled switch (S1, S2) are connected to a terminal (TP) for a gate pulse, in that the signal input of the first controlled switch (S1) is connected to a first current source (Q1), and the signal input of the second controlled switch (S2) is connected to a second current source (Q2), and in that the signal output of the first controlled switch (S1) is connected to the common terminal of the first difference amplifier (V1), and the signal output of the second controlled switch (S2) is connected to the common terminal of the second difference amplifier (V2).

7. Arrangement for regulating the modulation current of laser diodes used as optical transmitters in high bit rate digital communications transmission systems according to Patent Claim 5, characterized in that the input of a photocurrent amplifier (TV2) is connected to a terminal of the monitor photodiode (MD) of the optical transmitter, in that the output of the photocurrent amplifier (TV2) is connected to the signal inputs of a first and of a second sample-and-hold circuit (SH1, SH2), in that the control input of the first sample-and-hold circuit (SH1) is connected to a first terminal (SP1) for a first synchronous pulse, and the control input of the second sample-and-hold circuit (SH2) is connected to a second terminal (SP2) for a synchronous pulse, and in that the output of the first sample-and-hold circuit (SH1) is connected to the positive and the output of the second sample-and-hold circuit (SH2) is connected to the negative input of an operational amplifier (OPAMP) to whose output a terminal of the regulating system for the modulation current of the laser diode is connected.

## Revendications

1. Procédé pour régler le courant de modulation de diodes laser utilisées en tant qu'émetteurs optiques dans des systèmes numériques de transmission d'informations à cadence binaire élevée, et selon lequel une partie de la lumière produite est découplée au moyen d'une photodiode de contrôle appliquée optiquement à la diode laser, est convertie en un signal électrique et est utilisée pour produire un signal de régulation,
caractérisé par le fait
que le signal numérique de transmission contient périodiquement au moins une suite d'impulsions (IF), qui contient une ou plusieurs parties dans lesquelles les impulsions constituant un zéro logique ou les impulsions constituant un un logique sont prépondérantes, de sorte qu'un signal électrique produit par la photodiode de contrôle contient un signal impulsionnel possédant une amplitude constante et une répétition cyclique fixe, qui fournit une composante de signal possédant une fréquence comparativement basse, et
qu'un signal de réglage pour la régulation du courant de modulation est produit, à partir de la valeur d'amplitude de cette composante de signal, par comparaison à une valeur de référence.

2. Procédé suivant la revendication 1, caractérisé par le fait que la suite d'impulsions (IF) contient des parties, qui alternent réciproquement et présente des pourcentages accrus d'impulsions constituant des uns logiques ou d'impulsions constituant des zéros logiques.

3. Procédé suivant la revendication 1, caractérisé par le fait que le signal impulsionnel contenu périodiquement dans le signal numérique de transmission est la suite non codée de mots caractéristiques de trames du signal numérique de transmission.

4. Procédé suivant la revendication 1, caractérisé par le fait que la production du signal de réglage pour la régulation du courant de modulation s'effectue au moyen d'une détection synchrone du signal électrique, qui est produit par la photodiode de contrôle et par comparaison à une valeur de référence.

5. Procédé suivant la revendication 1, caractérisé par le fait que la production du signal de réglage pour la régulation du courant de modulation s'effectue à partir du signal électrique produit par la photodiode de contrôle, au moyen d'un échantillonnage périodique synchronisé du signal et d'une intégration d'une valeur d'échantillonnage à la manière du procédé dit "sample and hold".

6. Dispositif pour régler le courant de modulation de diodes laser utilisées comme émetteurs optiques dans des systèmes numériques de transmission d'informations à cadence binaire élevée suivant la revendication 4, caractérisé par le fait
qu'il est prévu un photoamplificateur (PV1), dont la borne d'entrée est reliée à la photodiode de contrôle de l'émetteur optique et dont la borne de sortie est reliée à une borne d'entrée d'un premier étage mélangeur (M1),
qu'il est prévu un filtre passe-bas (TPF), dont la borne d'entrée est reliée à une borne (DS), qui transmet le signal de transmission, du capteur optique et dont la borne de sortie est reliée aux secondes bornes des premier et second étages mélangeurs (M1,M2),
que la première borne de sortie du premier étage mélangeur (M1) est reliée à la seconde borne de sortie du second étage mélangeur (M2), à une borne (Reg) du dispositif de régulation branché en aval ainsi que, par l'intermédiaire d'une première résistance (R1) et d'un premier condensateur (C1), à un potentiel de référence,
que la seconde borne de sortie du premier étage mélangeur (M1) est reliée à la première borne de sortie du second étage mélangeur (M2), ainsi qu'à une autre borne (Reg 1, 2) pour le dispositif de régulation branché en aval ainsi que, par l'intermédiaire d'une seconde résistance (R2) et d'un second condensateur (C2), au potentiel de référence,
que la première borne d'entrée du second étage mélangeur (M2) est reliée, par l'intermédiaire d'une troisième résistance réglable (R3), à la sortie du filtre passe-bas (TPF),
que les entrées de commande de premier et second interrupteurs commandés (S1,S2) sont reliées à une borne (TP) pour une impulsion de porte,
que le signal d'entrée du premier interrupteur commandé (S1) est relié à une première source de courant (Q1) et que le signal d'entrée du second interrupteur commandé (S2) est relié à une seconde source de courant (Q2), et
que la sortie du signal du premier interrupteur commandé (S1) est reliée à la borne commune de ce premier amplificateur différentiel (V1) et que la sortie du signal du second interrupteur commandé (S2) est reliée à la borne commune du second amplificateur différentiel (V2).

7. Dispositif pour régler le courant de modulation de diodes laser utilisées comme émetteur optique dans des systèmes numériques de transmission d'informations à cadence binaire élevée, suivant la revendication 5, caractérisé par le fait
que l'entrée d'un amplificateur de courant photoélectrique (TV2) est reliée à une borne de la photodiode de contrôle (MD) du capteur optique,
que la sortie de l'amplificateur de courant photoélectrique (TV2) est reliée aux entrées de signaux de premier et second circuits d'échantillonnage et de blocage (SH1,SH2),
que l'entrée de commande du circuit d'échantillonnage et de blocage (SH1) est reliée à une première borne (SP1) pour une première impulsion de synchronisation et que l'entrée de commande du second circuit d'échantillonnage et de blocage (SH2) est reliée à une seconde borne (SP2) pour une impulsion de synchronisation, et
que la sortie du premier circuit d'échantillonnage et de blocage (SH1) et la sortie du second circuit d'échantillonnage et de blocage (SH2) sont raccordées la première à l'entrée positive et la seconde à l'entrée négative d'un amplificateur opérationnel (OPAMP), à la sortie duquel est raccordée une borne du circuit de régulation pour le courant de modulation de la diode laser.
